# EUROPEAN PATENT APPLICATION

(11) **EP 1 104 947 A2**
(43) Date of publication of application: **06.06.2001**
(21) Application number: 00124325.2
(22) Date of filing: 16.11.2000
(51) Int. Cl.: H01S 5/323

(54) **Nitride semiconductor laser and method for fabricating the same**

(30) Priority: 19.11.1999 JP 33023899
(71) Applicant: Pioneer Corporation, Meguro-ku, Tokyo (JP)
(72) Inventor: Ota, Hiroyuki, Tsurugashima-shi, Saitama 350-2288 (JP); Watanabe, Atsushi, Tsurugashima-shi, Saitama 350-2288 (JP); Tanaka, Toshiyuki, Tsurugashima-shi, Saitama 350-2288 (JP); Kimura, Yoshinori, Tsurugashima-shi, Saitama 350-2288 (JP); Miyachi, Mamoru, Tsurugashima-shi, Saitama 350-2288 (JP)
(74) Representative: Klingseisen, Franz, Dipl.-Ing.

(57) **Abstract**

A nitride semiconductor laser includes a substrate, a plurality of crystal layers made of group III nitride semiconductor (AlₓGa₁₋ₓ)_{1-y}In_{y}N (0≦x≦1, 0≦y≦1) and laminated on the substrate in this order and a metallic electrode formed so as to contact an outermost layer of the crystal layers. The outermost layer is sandwiched by the metallic electrode and a high-impurity-concentration crystal layer having group II impurities having a concentration higher than concentrations of group II impurities of a crystal layer immediately below the high-impurity-concentration crystal layer and the outermost layer.

## Description

### BACKGROUND OF THE INVENTION

### 1. Field of the invention

The present invention relates to a group III nitride semiconductor device (hereinafter also referred to as device), particularly to a semiconductor laser device fabrication method using the same material system.

### 2. Description of the related art

A semiconductor laser is operated with applying electric current to a strip portion having a width of several microns. Therefore, the current density of an electrode portion to which current is supplied is much higher than that of an LED (Light Emitting Diode). To provide a practical ohmic electrode for a semiconductor laser, low contact resistance, sufficient adherence between a semiconductor and a metal, availability for wire-bonding, and long-term stability are required.

To obtain low contact resistance, higher carrier concentration as well as narrower band-gap are preferable for the underlying semiconductor layer. Therefore, it is a common practice to adopt highly doped GaAs for a contact layer of a GaAlAs-based semiconductor laser and InGaAs for an InGaAsP-based semiconductor laser.

In the case of a p-type contact layer, the carrier density may be enhanced during the crystal growth or by diffusion process after the growth. Moreover, alloying may be performed after forming a metallic electrode.

In the case of a GaN-based semiconductor laser, the contact resistance of the p-side electrode portion is high and moreover, the current density (threshold current density) necessary for laser oscillation is higher than that of a semiconductor laser with a conventional material. That increases the operating voltage of a GaN-based semiconductor laser device and thereby increases the heat generated in a device. The increase of heat generation in the GaN-based semiconductor device causes large temperature rise, which shortens the device life-time.

One of the general rules for obtaining a good p-type ohmic contact between metal and semiconductor is to choose a metal having a work function larger than the energy difference between the vacuum level and the valence band of the semiconductor. However, actual metals may not fulfil this requirement.

GaN is a wide-gap semiconductor material and has a deep valance band.

Realization of an ideal ohmic contact according to the above scheme necessitates a metal having so large work function that no such metal has been found so far.

Second method, which is commonly performed as mentioned above, for producing a practically low contact resistance is to increase the carrier concentration in the semiconductor at the interface to the metal layer. This method utilizes the phenomenon in which a doping to the semiconductor layer with sufficiently high concentration reduces the thickness and effective height of the Schottky barrier formed at the metal/semiconductor interface. In this method, the carrier density of the semiconductor in contact with the metallic electrode is set to approximately 10¹⁸ cm⁻³.

Though it is not easy to produce a highly p-type GaN film, a hole concentration on the order of 10¹⁸ cm⁻³ can be obtained by optimizing growth condition and post-growth heat treatment. According to the experience on GaAs-based lasers, GaN-based laser device with this carrier concentration is expected to exhibit an ohmic contact with sufficiently low resistance.

However, the current-voltage characteristic of an actual GaN-based semiconductor laser is often found to be inferior to that expected from the above carrier concentration. Since the band-gap of the material that constitutes the junction is 3 eV, the turn-on voltage of the device is expected to be around 3 V. On the contrary, the current-voltage curve of an actual GaN-based laser does not rise until the applied voltage substantially exceeds 3v.

Thus, different from the conventional GaAs-based laser, a GaN-based semiconductor laser has a problem that the contact resistance does not correspond to the carrier concentration.

### OBJECT AND SUMMARY OF THE INVENTION

Therefore, it is an object of the present invention to provide a group III nitride semiconductor laser and fabrication method therefor capable of producing an electrode structure with low contact resistance and high reproducibility.

A nitride semiconductor laser according to the present invention comprises: a substrate; a plurality of crystal layers made of group III nitride semiconductor (AlₓGa₁₋ₓ)_{1-y}In_{y}N (0≦x ≦1, 0≦y≦1) laminated on the substrate in order; and a metallic electrode formed so as to contact an outermost layer of the crystal layers, wherein the outermost layer is sandwiched by the metallic electrode and a high-impurity-concentration crystal layer having a concentration of group II impurities higher than those of the layer immediately below and the outermost layer.

In one aspect of the nitride semiconductor laser according to the present invention, the polarity of a growing crystal layer is inverted by an insertion of the high-impurity-concentration crystal layer.

In another aspect of the nitride semiconductor laser according to the present invention, the growth direction of the crystal layer immediately below the high-impurity-concentration crystal layer is <0001> direction and a crystal growth orientation is inverted to <0001> direction [hereinafter shown as <000-1> in this specification] by forming the high-impurity-concentration crystal layer.

In a further aspect of the nitride semiconductor laser according to the present invention, the high-impurity-concentration crystal layer for inverting a growth orientation is located in the middle of a p-GaN contact layer immediately below a p-side metal electrode.

In a still further aspect of the nitride semiconductor laser according to the present invention, the substrate applies an in-plane compressive stress to the outermost layer.

In another aspect of the nitride semiconductor laser according to the present invention, the substrate is made of sapphire.

In a further aspect of the nitride semiconductor laser according to the present invention, the group-II-impurity is Mg and the concentration of Mg of the high-impurity-concentration crystal layer exceeds 2 x 10²⁰ cm⁻³.

In a further aspect of the nitride semiconductor laser according to the present invention, Mg concentrations in the outermost layer immediately on the high-impurity-concentration crystal layer and a crystal layer immediately below the high-impurity-concentration crystal layer are kept in the range of 1 x 10¹⁹ to 1 x 10²⁰ cm⁻³.

In a still further aspect of the nitride semiconductor laser according to the present invention, Mg concentrations of the outermost layer immediately on the high-impurity-concentration crystal layer and a layer immediately below the high-impurity-concentration crystal layer are substantially the same.

A method for fabricating a nitride semiconductor laser having a plurality of crystal layers made of group III nitride semiconductor (AlₓGa₁₋ₓ)_{1-y}In_{y}N (0≦x≦1, 0≦y≦1) according to the present invention, comprises:
a crystal-layer forming step of growing a plurality of crystal layers with a single growth direction;
a high-impurity-concentration crystal layer forming step of forming a crystal layer having a concentration of group II impurities higher than the concentration of group II impurities in a crystal layer immediately before the crystal layers;
an outermost-layer forming a crystal layer having a concentration of group II impurities lower than the concentration of group II impurities of the high-impurity-concentration crystal layer onto the high-impurity-concentration crystal layer; and
an electrode forming step of forming a metal electrode on the outermost layer of the crystal layers.

In one aspect of the fabrication method according to the present invention, the crystal layers are formed by metal-organic chemical vapor deposition.

In another aspect of the fabrication method according to the present invention, most of the crystal layer are grown in the <0001> direction up to the crystal layer immediately below the high-impurity-concentration crystal layer, then by virtue of the high-impurity-concentration crystal layer the polarity of crystal is inverted <0001> direction.

In a further aspect of the fabrication method according to the present invention, the substrate is made of sapphire.

In a still further aspect of the fabrication method according to the present invention, the group-II-impurity is Mg and the concentration of the high-impurity-concentration crystal layer exceeds 2 x 10²⁰ cm⁻³.

In another aspect of the fabrication method according to the present invention, Mg concentrations of the outermost layer immediately on the high-impurity-concentration crystal layer and a crystal layer immediately below the high-impurity-concentration crystal layer are set in the range of 1 x 10¹⁹ to 1 x 10²⁰ cm⁻³.

In a further aspect of the fabrication method according to the present invention, Mg concentrations of the outermost layer immediately on the high-impurity-concentration crystal layer and a crystal layer immediately below the high-impurity-concentration crystal layer are substantially the same.

### BRIEF DESCRIPTION OF THE DRAWINGS

Fig. 1 is a schematic sectional view of a ridge-type semiconductor laser device fabricated according to an embodiment of the present invention;
Fig. 2 is a schematic enlarged local sectional view of of the p-side electrode portion of the semiconductor laser shown in Fig. 1;
Fig. 3 is a differential interference microphotograph showing the crystal surface of a GaN crystal film with N polarity;
Fig. 4 is a differential interference microphotograph showing the crystal surface of a GaN crystal film with Ga polarity;
Fig. 5 is a graph showing voltage-current characteristics of a semiconductor laser having GaN crystal films of N polarity and a semiconductor laser having GaN crystal films of Ga polarity;
Figs. 6A to 6C are band diagrams each showing the shape of balance band edge near the p-side electrode of a device having a GaN contact layer.
Fig. 7 is a graph showing atomic depth profiles of Mg and Al measured by SIMS (Secondary Ion Mass Spectrometry) in the vicinity of the surface of a contact portion of a laser wafer fabricated according to the present invention;
Fig. 8 is a differential interference microphotograph showing the crystal surface of a contact layer of a laser wafer fabricated according to an embodiment of the present invention;
Fig. 9 is a graph showing voltage-current characteristics of a semiconductor laser fabricated according to an embodiment of the present invention; and
Figs. 10 to 13 are schematic sectional views each showing a laser wafer in the steps of fabricating a semiconductor laser of an embodiment of the present invention.

### DETAILED DESCRIPTION OF THE PREFERRED EMBODIMENT

A group III nitride semiconductor laser of an embodiment of the present invention is described below by referring to the accompanying drawings.

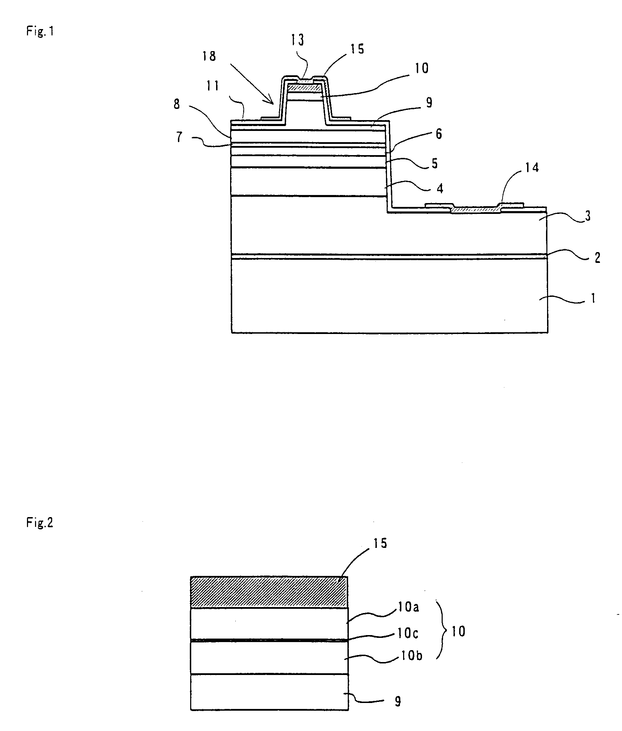

Fig. 1 shows an example of a semiconductor laser device according to the present invention, which is a ridge-type laser device of an SCH (Separate Confinement Heterostructure). Reference number 1 denotes a single-crystal sapphire substrate, 2 denotes a GaN (or AlN) layer formed at a low temperature, 3 denotes an n-type GaN layer, 4 denotes an n-type Al_{0.1}Ga_{0.9}N layer, 5 denotes an n-type GaN layer, 6 denotes an active layer mainly composed of In GaN, 7 denotes a p-type Al_{0.2}Ga_{0.8}N layer, 8 denotes a p-type GaN layer, 9 denotes a p-type Al_{0.1}Ga_{0.9}N layer, 10 denotes a p-type GaN layer doped with a group-II-impurity such as Mg, 14 denotes an n-side electrode, 13 and 15 denote p-side electrodes, 18 denotes a ridge, and 11 denotes an insulating film made of SiO₂.

Light is emitted from the active layer by recombining electrons and holes. The n-type GaN layer 5 and p-type GaN layer 8 are waveguide layers for guiding the light emitted from the active layer. By setting the band gap of a guide layer to a value larger than that of the active layer 6, electrons and holes are effectively confined in the active layer. The p-type Al_{0.2}Ga_{0.8}N layer 7 is a barrier layer for further enhancing the confinement of injected carriers (particularly, electrons). The n-type Al_{0.1}Ga_{0.9}N layer 4 and p-type Al_{0.1}Ga_{0.9}N layer 9 are cladding layers with a refractive index lower than that of the waveguide layers 5 and 8, which confine the ewitted light into the waveguide layers duo to the difference in refractive indexes. The ridge portion 18 is formed so as to produce a step in effective refractive index along the lateral direction generated by a change in the thickness of the cladding layer on the waveguide layer, and thereby laterally confining the emitted light. The n-type GaN ground layer 3 provides a current path for device on an electrically insulating substrate. The low-temperature-grown GaN (or AlN) layer 2 is a so-called buffer layer, which is disposed so as to provide a smooth film on a sapphire substrate which is a dissimilar material to GaN.

As described above, a nitride semiconductor laser according to the present invention comprises a plurality of laminated crystal layers 2 to 10 made of a group III nitride semiconductor (AlₓGa₁₋ₓ)_{1-y}In_{y}N (0≦x≦1, 0≦y≦1) and metal electrode 15 formed on the outermost layer.

In the case of the nitride semiconductor laser according to the present invention, as shown in Fig. 2, the contact layer 10 contains a high-impurity-concentration layer 10c held between a first outermost layer 10a close to a p-side electrode and a second outermost layer 10b close to an active layer. The thin high-impurity-concentration crystal layer 10c having a thickness of 0 to 100 Å has a group-II-impurity concentration larger than the concentration of a group-II-impurity such as Mg or the like contained in the crystal layers 10a and 10b.

In the present invention, in addition to an increased carrier concentration, polarization induced by the piezoelectric effect of GaN-related semiconductor crystal further reduces the schottky barrier height. The high-impurity-concentration layer 10c is formed to determine the polarity of the GaN-related crystal grown thereon. The insertion of the high-impurity-concentration layer 10c flips the polarity of the layer 10a grown thereon from that of the second outermost layer 10b so as to invert the direction of produced piezoelectric polarization. Specifically, the first outermost layer 10a close to the p-side electrode is formed to have a the growth orientation of <000-1> , whereas the second outermost 10b has a growth orientation of <0001>.

The thermal expansion coefficient of the sapphire substrate 1 is larger than that of GaN-based semiconductor crystal. Thus, the GaN-based semiconductor crystal layers 2 to 10 grown on the sapphire substrate 1, are under strong in-plane compressive stress caused by the large temperature difference during the cooling stage after the crystal growth. In the case of the GaN-based laser device according to the present invention, this in-plane stress generates high carrier concentration at the metal/semiconductor interface and thereby reducing the Schottky barrier height.

The crystal structure of GaN is referred to as the so-called "wurtzite type" and has a hexagonal crystal structure. The axis of the hexagonal prism is referred to as C axis or <0001> axis. GaN film on a crystalline substrate made of sapphire or the like is generally grown as a crystal layer having its C axis normal to the primary plane substrate. Therefore, the C plane (a plane normal to the C axis) appears on the surface of the GaN film formed on the sapphire substrate. A GaN crystal does not have mirror-image symmetry to the C axis. Thus, single-crystal GaN film on a sapphire substrate can be grown with two polarities, i.e., +C and -C planes. The +C plane has a polarity in which one of four bonds of each Ga atom extetnds to the outside of the film and the remaining three bonds extetnd into the film. Conversely, the -C plane has a polarity in which three bonds of each N atom extetnd into the film. Therefore, the +C plane may be referred to as a Ga (gallium) plane and the -C plane may be referred to as a N (nitrogen) plane. The fact that GaN crystal has two polarities (one is Ga polarity and the other is N polarity) greatly influences various characteristics of a GaN-based semiconductor crystal.

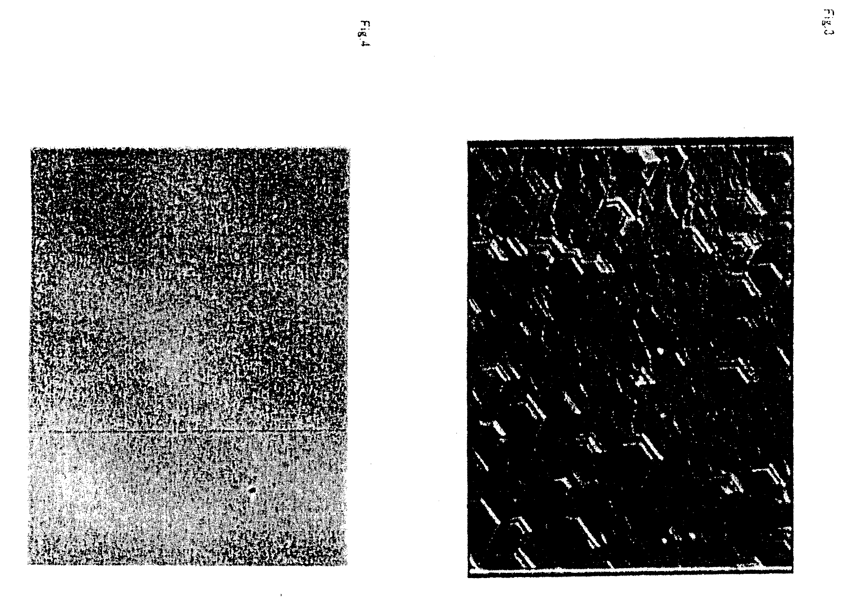

Particularly, the N polarity crystal is inferior in film surface flatness and easily causes a hexagonal protrusion as shown in Fig. 3. In the case of a crystal with Ga polarity, however, a smooth film is comparatively easily and reproducibly obtained and its surface flatness is far superior to that of N polarity film as shown in Fig. 4. Moreover, the growing surface of a N polarity crystal easily captures a donor-like impurity such as oxygen. As a result of our study, a p-type carrier concentration of up to only the order of a 10¹⁷ cm⁻³ is obtained in the case of a film with N polarity. The Ga plane has advantages that a carrier concentration of up to 3 x 10¹⁸ cm⁻³ is obtained and less oxygen impurities are captured.

A semiconductor laser also serves as a waveguide device and has a stacked structure consisting of a number of layers having various refractive indexes. To reduce the wave-guiding loss due to scattering of light, it is necessary that the interface between layers constituting a device is sufficiently flat. From this point of view, it is impossible to fabricate a laser device having a preferable characteristic by using a crystal of N polarity. At present, a GaN-based semiconductor layers are generally fabricated with Ga polarity of GaN crystal grown on sapphire substrate.

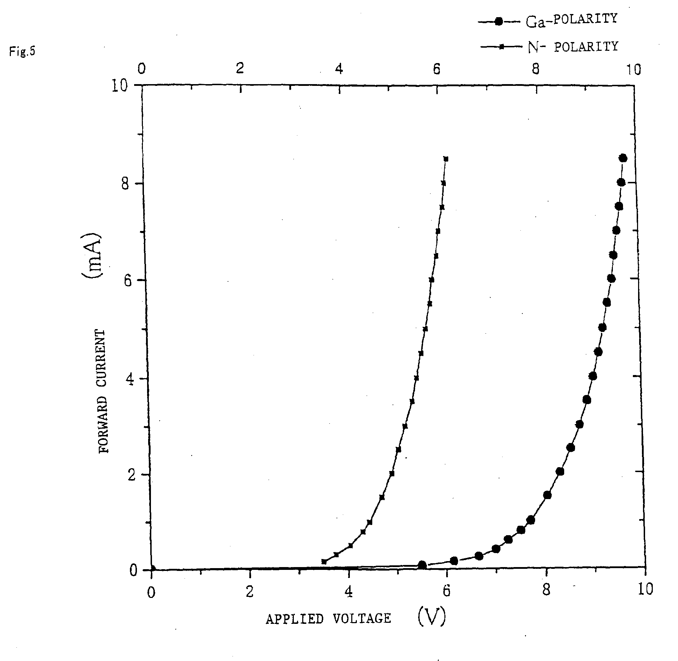

The present inventors fabricated a laser structure on a N polarity GaN layer by controlling the initial stage of the crystal growth. Fig. 5 shows the voltage-current characteristic (denoted by ●) of the resultant GaN semiconductor laser of N polarity. For comparison, the characteristic of a GaN semiconductor laser of Ga polarity (denoted by ■) is also shown in Fig. 5. From Fig. 5, it is found that the curve for the device of N polarity rises at much lower voltage. Since InGaN alloy consisting the junction has a band gap of approximately 3 eV, the turn-on voltage of the device is expected to be around 3 V. However, as shown in Fig. 5, current curve does not rise until the voltage reaches a point much higher than 3 V. That indicates the existence of an electronic barrier due to an insufficient contact at the p-side electrode. In the case of a device of Ga polarity, the carrier concentration of the contact layer immediately below the p-side electrode is set to be 3 x 10¹⁸ cm⁻³, which is considered to be a sufficient value.

As described above, in the case of the film with N polarity, a sufficient p-type carrier concentration cannot be obtained (in the case of the device in Fig. 5, the carrier concentration of a layer adjacent to the p-side electrode is equal to 1.5 x 10¹⁷ cm⁻³) and the carrier concentration is lower than that of Ga polarity by one digit or more. Despite much lower carrier concentration than that of Ga polarity, a N polarity device exhibits superior contact characteristic and lower turn-on voltage. It is uncommon for other semiconductor materials that a contact with higher carrier concentration exhibits poorer characteristic whereas lower carrier concentration results in a device with lower contact resistivity. It is estimated that a strong piezoelectric characteristic of a GaN-based semiconductor causes such phenomenon.

Piezoelectric effect is a phenomenon in which an electric polarization is induced by the stress applied to the crystal. In the case of GaN crystal grown on a sapphire substrate, a compressive strain occurs in the GaN film due to a difference between thermal expansion coefficients of the GaN film and the substrate. Naturally, even if strains are the same, directions of generated polarization are changed when orientations of the crystal are changed (for example, direction is inverted). When electrostatic polarization occurs in a semiconductor crystal, the distribution of carriers is modified from that in the absence of polarization.

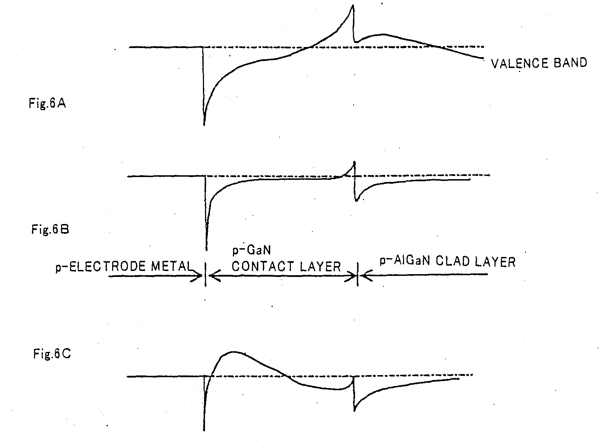

A phenomenon deduced to occur in GaN-based semiconductor having the piezoelectricity is described by referring to Figs. 6A to 6C. Fig. 6B is a schematic view showing an energy band structure in the vicinity of the p-side electrode of a laser device fabricated with GaN crystal assuming the absence of piezoelectricity. Fig. 6A is a schematic view showing an energy band structure in the vicinity of the p-side electrode of a laser device fabricated of a GaN crystal with Ga polarity. Fig. 6C is a schematic view showing an energy band structure in the vicinity of p-side electrode of a laser device fabricated with a GaN crystal of N polarity.

As shown in Fig. 6A, the piezoelectric polarization has carriers (holes) move to counterbalance the electric field induced by the polarization itself. As a result, the carrier concentration in the vicinity of the electrode becomes lower than the case shown in Fig. 6B and the thickness of a Schottky barrier becomes larger than the case shown in Fig. 6B.

On the contrary, in the case of a device formed on a crystal of N polarity, carriers (holes) move toward the vicinity of the electrode as shown in Fig. 6C and carriers (holes) move to accumulate in the vicinity of the electrode at a concentration much higher than expected from the characteristic of an independent p-GaN film . As a result, it is considered that the device with N polarity exhibits a better electrode characteristic despite its lower carrier concentration.

A crystal layer with N polarity is superior in terms of p-side electrode characteristic alone but inferior in surface flatness as described above, and therefore, N polarity is difficult to be applied to laser devices. Moreover, though the reason is unknown yet, a crystal with N polarity usually has higher threading dislocation density and the luminous property is therefore generally inferior.

The present invention provides a practical semiconductor laser by introducing the advantages of two crystal polarities of GaN. That is, the present invention introduces a high-impurity-concentration layer in the middle of the p-GaN film (contact layer) to invert the polarity of the outermost part of the film to N polarity and thereby improving the electrode characteristics without sacrificing flatness of the interfaces or luminous properties of the device.

Formation of the high-impurity-concentration crystal layer, is carried out by performing a growth step for forming said layer in which the concentration of Mg serving as an acceptor dopant is locally set at a very high value during the growth of p-GaN contact layer 10. When the thickness of a p-GaN contact layer (set Mg concentration: 4 x 10¹⁹ cm⁻³) reaches approximately 0.1µm out of the total set thickness of 0.2 µm, the amount of Et-Cp₂Mg (ethyl-biscyclopentadienyl magnesium) of Mg precursor to be supplied is increased up to 10 times and the supply of TMG (trimethylgallium) serving as Ga precursor is decreased to 1/2. After keeping the above state for a period corresponding to a thickness of approximately 100 Å, the supply of precursors is returned to original values and the remaining 0.1µm of the film was formed to complete the growth of the wafer. It is preferable that Mg concentration of the p-GaN contact layer other than the portion where the polarity inversion takes place is kept in the range of 1 x 10¹⁹ to 1 x 10²⁰ cm⁻³. Unless the Mg concentration is kept in the above range, a value of 10¹⁷ cm⁻³ or more is not obtained as the carrier concentration of p-GaN electrical characteristics of a device cannot be sufficiently improved.

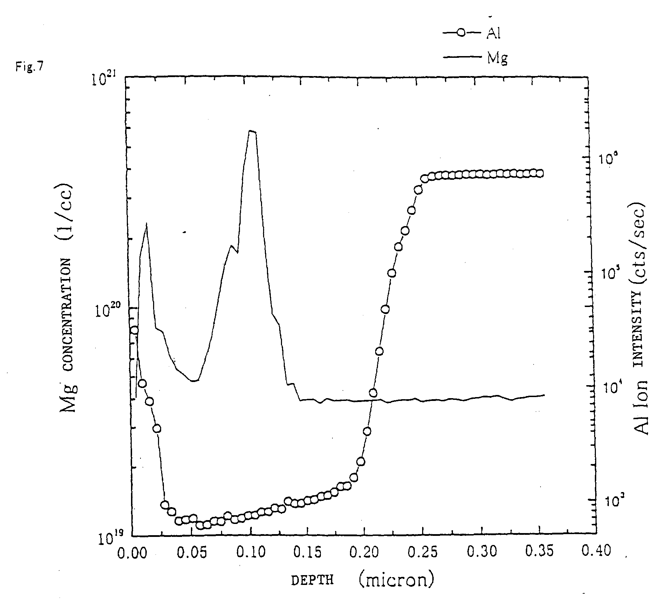

Fig. 7 shows an SIMS (Secondary Ion Mass Spectrometry) results taken from the vicinity of the surface of a laser wafer according to the present invention. In this figure, only the results on Al and Mg are shown. The depth of about 0.2 µm corresponds to the interface between p-GaN contact layer and p-AlGaN cladding layer. The Mg concentration of the portion corresponding to the increased Mg supply reaches 6 x 10²⁰ cm⁻³.

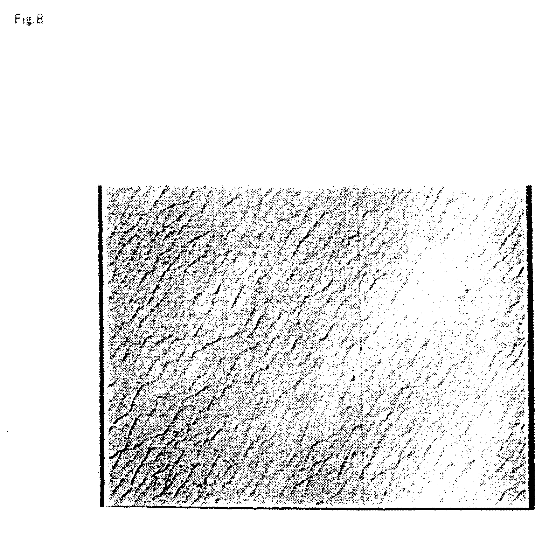

Fig. 8 is a differential interference microphotograph showing the crystal surface of the contact layer of the wafer. The surface is somewhat smoother than that of the N polarity film shown in Fig.3, but exhibits a scale-like feature. The scale-like surface morphology imparts the depth resolution of the SIMS profile shown in Fig. 7. Moreover, though not shown in Fig. 7, oxygen was detected with a concentration of approximately 1.5 x 10¹⁸ cm⁻³ in the surface-side layers including the high-impurity-concentration layer. The Oxygen concentration was kept below the background level in other layers. Judging from these facts, the polarity of the upper layers are invented from Ga polarity to N polarity.

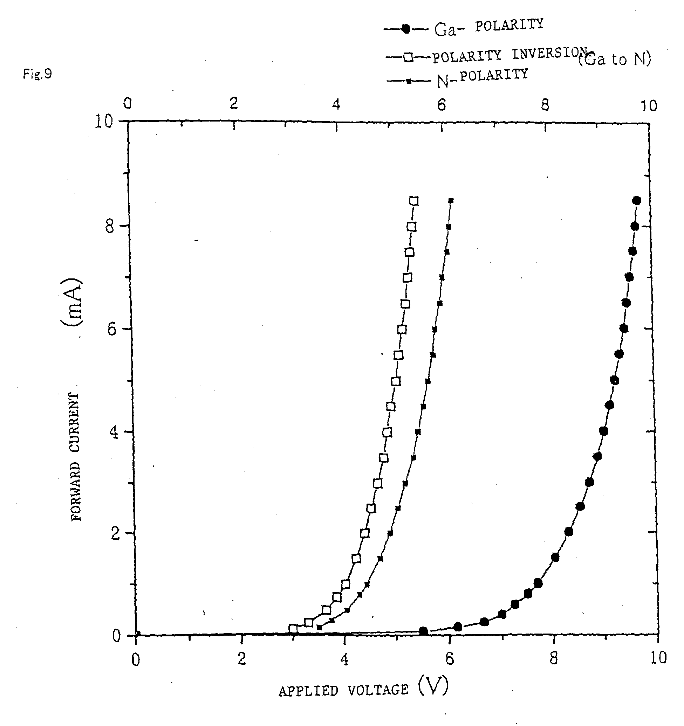

Fig. 9 shows the current-voltage characteristic (denoted by □) of a device fabricated from the wafer with the inversion from Ga polarity to N polarity. For comparison, Fig. 9 also shows the characteristic of a normal laser device with Ga polarity (denoted by ●) and that of a N polarity device (denoted by ■).

As is apparent from Fig. 9, the device with polarity inversion exhibits a slightly better characteristic than that of the device with N polarity. This is probably because the second outermost layer in the device with polarity inversion has higher carrier concentration and thus lower resistivity than the outermost layer next to the p-side electrode of the N e polarity device.

The polarity inversion can be obtained even with a minute thickness(100 Å or less, down to the order of monolayer) of high-impurity-concentration layer inserted into the contact layer. Moreover, a high-impurity-concentration layer has a low carrier concentration, it is desirable that the thickness of the layer be small from the viewpoint of electric conductivity.

When setting the Mg concentration of a high-impurity-concentration layer to be 2 x 10²⁰ cm⁻³ or less, neither the change of surface morphology nor the enhancement of oxygen incorporation were observed, suggesting the absence of polarity inversion.

Moreover, forming the high-impurity-concentration layer on the surface of a wafer, only makes the device operating voltage higher. This is because the high-impurity-concentration layer itself has a low carrier concentration and is similar to an insulator and thereby increasing the thickness of the barrier at the metal/semiconductor inter face.

The step of fabricating the laser device of the above embodiment including the step of forming a high-impurity-concentration layer is described below in detail.

First, a sapphire substrate 1 is set in an MOCVD reactor and held in a hydrogen-gas flow at a temperature of 1050° C and a pressure of 300 Torr to thermally clean the surface of the sapphire substrate 1. Then, the sapphire substrate 1 is cooled until its temperature reaches 600° C, ammonia (NH₃) serving as a nitrogen precursor and TMA (trimethylaluminum) serving as Al precursor are introduced into the reactor to deposit a buffer layer 2 made of AlN up to a thickness of 20 nm.

Then, the supply of TMA is stopped and the temperature of the sapphire substrate 1 on which the buffer layer 2 is formed is raised to 1050° C again while only NH₃ is fed to form an n-type GaN ground layer 3 by introducing trimethylgallium (TMG). In this case, Me-SiH₃ (methyl silane) is added to a growth atmosphere as the precursor of Si which as serves an n-type impurity.

After the n-type GaN ground layer 3 is grown to approximately 4 µm, an n-type AlGaN cladding layer 4 is formed by introducing TMA. After the n-type AlGaN cladding layer 4 is grown to approximately 0.5 µm, the supply of TMA is stopped to grow an n-type GaN guide layer 5 up to 0.1 µm. When growth of the n-type GaN guide layer 5 is completed, supply of TMG and Me-SiH₃ is stopped and cooling is started to lower the substrate temperature to 750° C. When the substrate temperature reaches 750° C, carrier gas is changed from hydrogen to nitrogen. When the gas flow is stabilized, an active layer 6 is grown by introducing TMG, TMI, and Me-SiH₃. After the active layer is formed, supply of TMG, TMI, and Me-SiH₃ is stopped and carrier gas is changed from nitrogen to hydrogen. When the gas flow is stabilized, the substrate temperature is raised to 1050° C again to form a p-type AlGaN layer 7 up to 0.01 µm by introducing TMG, TMA, and Et-Cp₂Mg (ethyl-biscyclopentadienyl magnesium) as precursor of Mg which serves as a p-type impurity. Then, the supply of TMA is stopped, a p-type GaN guide layer 8 is grown to 0.1 µm, and then a p-type AlGaN cladding layer 9 is grown to 0.5 µm by introducing TMA again.

At this time, the step of the contact layer 10 is performed. A second outermost layer 10b made of p-GaN (set Mg concentration: 4 x 10¹⁹ cm⁻³) is grown to approximately 0.1 µm on the cladding layer 9. Then, the supply amount of Et-Cp₂Mg is increased up to ten times of that in the provious step, while the supply amount of TMG as a Ga material is decreased to 1/2, and this state is kept for a period corresponding to a film thickness of 100 Å to form a high-impurity-concentration layer 10c. After, the supply amounts of the precursors are returned to the original values, the first outermost layer 10a is formed with a thickness of approximately 0.1 µm, and thus a p-type GaN contact layer 10 having a total thickness of 0.2 µm is formed to complete the wafer.

When the growth is completed, supply of TMG and Et-Cp₂Mg is stopped and cooling is started. When the substrate temperature reaches 400° C, supply of NH₃ is stopped. After the substrate temperature reaches room temperature, the wafer is taken out of the reactor. The resultant wafer is set in a heat a treatment furnace to perform a heat treatment to obtain p-type conductivity.

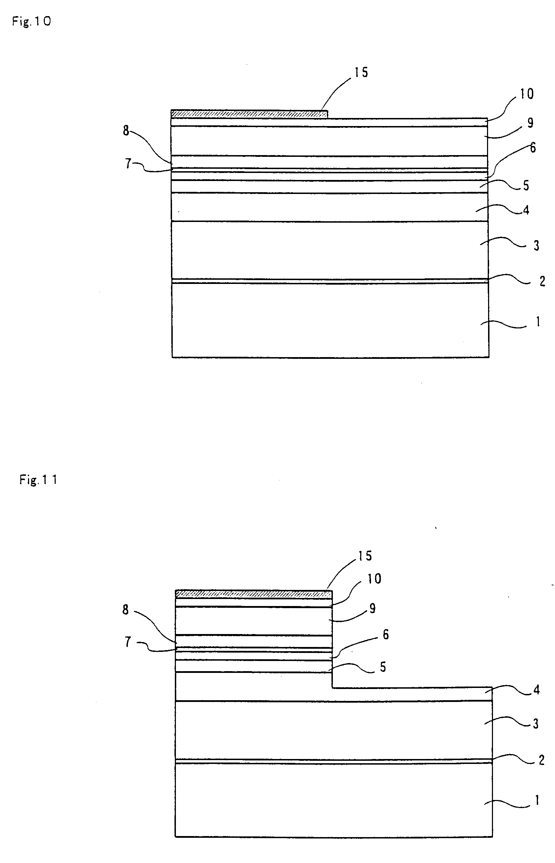

As shown in Fig. 10, a Ni (nickel) film 15 is formed as a p-side electrode on the p-type layer by vacuum evaporation.

A p-side mesa, a current path structure for n-side electrode, and then a ridge shaped portion on the p-side mesa are fabricated on the wafer. The ridge shaped portion serves as a refractive-index-waveguide and also confines the injected current.

The formation of the current path for the n-side electrode is performed first by partially removing the Ni film and then by etching the exposed nitride layer using reactive ion etching(RIE) with Cl₂ (chlorine) gas utilizing the Ni film as a mask. At this time, etching is performed up to a depth at which the n-type cladding layer 4 is slightly left to form a bottom portion 201 of the mesa structure.

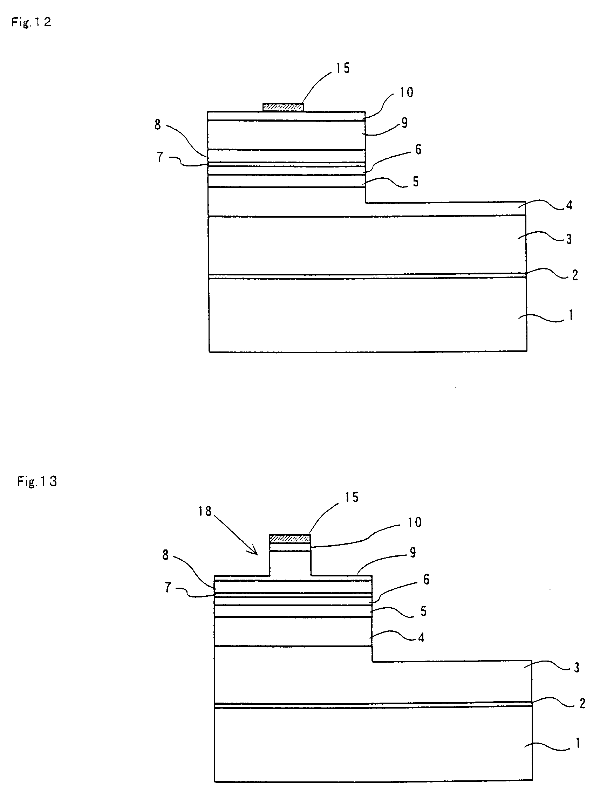

Then, as shown in Fig. 12, the Ni film is removed by wet etching while leaving a Ni film stripe 15 having a width of 5 µm.

Then, portions other than the portion immediately below the 5 µm-wide stripe portion, that is, the contact layer 10 and p-type AlGaN cladding layer 9 are removed while leaving approximately 0.1 µm of the cladding layer 9 by reactive ion etching (RIE) using the Ni stripe 15 as a mask to form a narrow ridge structure 18 as shown in Fig 13. In this case, remaining n-type cladding layer 4 is also removed and the n-type GaN ground layer 3 is partially exposed.

A SiO₂ protective film is deposited on the above wafer by sputtering or the like. A 3 µm-wide window on the p-type ridge portion and a window portion on the n-side electrode are formed the SiO₂ protective film by a normal photolithography. Ti (titanium) with a thickness of 50 nm is evaporated onto a portion where the n-type GaN layer 3 is exposed and then, Al (aluminum) with a thickness of 200 nm is deposited on the portion to form an n-side electrode 14. Ni (nickel) with a thickness of 50 nm is evaporated onto the top of the p-side mesa and then Au (gold) with a thickness of 200 nm is deposited to form a p-side electrode 13. Thus, the structure shown in Fig. 1 is formed as an individual device on the wafer.

## Claims

1. A nitride semiconductor laser comprising; a substrate; a plurality of crystal layers made of a group III nitride semiconductor (AlₓGa₁₋ₓ)_{1-y}In_{y}N (0≦x<1, 0≦y≦1) and laminated on the substrate in order; and a metallic electrode formed on an outermost layer of the crystal layers, wherein a crystal layer for holding the outermost layer together with the metallic electrode is a high-impurity-concentration crystal layer and the high-impurity-concentration crystal layer contains group II impurities having a concentration higher than concentrations of group II impurities of a crystal layer immediately below the high-impurity-concentration crystal layer and the outermost layer.

2. A nitride semiconductor laser according to claim 1, wherein a growth orientation of the crystal layer grown from the substrate is inverted by forming the high-impurity-concentration crystal layer.

3. A nitride semiconductor laser according to claim 1, wherein a main growth orientation of the crystal layer immediately below the high-impurity-concentration crystal layer is substantially <0001> direction and a crystal growth orientation is inverted to substantially <000-1> direction by forming the high-impurity-concentration crystal layer.

4. A nitride semiconductor laser according to claim 1, wherein a position of the high-impurity-concentration crystal layer for inverting a growth orientation is in the middle of a p-GaN contact layer immediately below a p-side metallic electrode.

5. A nitride semiconductor laser according to claim 1, wherein the substrate applies an in-plane compressive stress to the outermost layer.

6. A nitride semiconductor laser according to claim 1, wherein the substrate is made of sapphire.

7. A nitride semiconductor laser according to claim 1, wherein the group-II-impurity is Mg and the concentration of Mg of the high-impurity-concentration crystal layer exceeds 2 x 10²⁰ cm⁻³.

8. A nitride semiconductor laser according to claim 7, wherein Mg concentrations in the outermost layer immediately on the high-impurity-concentration crystal layer and a crystal layer immediately below the high-impurity-concentration crystal layer are kept in a range of 1 x 10¹⁹ to 1 x 10²⁰ cm⁻³.

9. A nitride semiconductor laser according to claim 7, wherein Mg concentrations of the outermost layer immediately on the high-impurity-concentration crystal layer and a crystal layer immediately below the high-impurity-concentration crystal layer are substantially the same.

10. A fabrication method of a nitride semiconductor laser having a plurality of crystal layers made of group III nitride semiconductor (AlₓGa₁₋ₓ)_{1-y}In_{y}N (0≦x≦1, 0≦y≦1), comprising the steps of:
forming a plurality of crystal layers with a substantially constant growth orientation;
forming a high-impurity-concentration crystal layer having a group-II-impurity concentration higher than the group-II-impurity concentration of the crystal layer immediately below the high-impurity-concentration crystal layer;
forming an outermost layer of crystal layers having a group-II-impurity concentration lower than the group-II-impurity concentration of the high-impurity-concentration crystal layer; and
forming a metallic electrode on the outermost layer of the crystal layers.

11. A fabrication method according to claim 10, wherein the crystal layers are formed by metal-organic chemical vapor deposition.

12. A fabrication method according to claim 10, wherein, up to a crystal layer immediately below, the high-impurity-concentration crystal layer is grown by setting a main growth orientation to substantially <0001> direction, the high-impurity-concentration crystal layer forming step is included, and the growth orientation of crystal is inverted to substantially <000-1> direction in the vicinity of the high-impurity-concentration crystal layer.

13. A fabrication method according to claim 10, wherein the substrate is made of sapphire.

14. A fabrication method according to claim 10, wherein the group-II-impurity is Mg and the concentration of the high-impurity-concentration crystal layer exceeds 2 x 10²⁰ cm⁻³.

15. A fabrication method according to claim 14, wherein Mg concentrations of the outermost layer immediately on the high-impurity-concentration crystal layer and a crystal layer immediately below the high-impurity-concentration crystal layer are kept in a range of 1 x 10¹⁹ to 1 x 10²⁰ cm⁻³.

16. A fabrication method according to claim 14, wherein Mg concentrations of the outermost layer immediately on the high-impurity-concentration crystal layer and a crystal layer immediately below the high-impurity-concentration crystal layer are substantially the same.
